# EUROPÄISCHE PATENTANMELDUNG

(11) **EP 0 795 891 A2**
(43) Veröffentlichungstag der Anmeldung: **17.09.1997**
(21) Anmeldenummer: 97104275.9
(22) Anmeldetag: 13.03.1997
(51) Int. Cl.: H01L 21/00

(54) **Auflöten von Halbleiterchips**

(30) Priorität: 14.03.1996 DE 19610112
(71) Anmelder: D-Tech GmbH Antriebstechnik und Mikroelektronik, 33689 Bielefeld (DE)
(72) Erfinder: Gabriel, Rupprecht, 33689 Bielefeld (DE)
(74) Vertreter: Leonhard, Frank Reimund, Dipl.-Ing.

(57) **Zusammenfassung**

Die Erfindung betrifft ein Verfahren zum positionsgenauen Auflöten von flächigen Halbleiterchips (1) auf ein Substrat (20), bei dem ein Vakuum (V2) in einem Lötraum (30) ein Oberteil (3) gegenüber einem Unterteil (4) relativbewegt und die an dem Oberteil (3) seitenstabil gehaltenen - eines oder mehrere - Chips (1) in das erwärmte Lot (9,10) hineindrückt sowie eine Einrichtung zum Durchführen dieses Verfahrens. Ferner wird Lotmaterial zur Anbringung von großen Halbleiterchips, insbesondere Leistungshalbleitern (1), bereitgestellt, mit einem bei einer Schmelztemperatur flüssig werdenden Lötbestandteil (9) und einer Vielzahl von Körnern (10), die gegenüber dem Lötmaterial resistent sind und eine Schmelztemperatur haben, die höher liegt, als die Schmelztemperatur des Lotbestandteils (9).

## Beschreibung

Das technische Gebiet der Erfindung sind Lötverfahren zur Befestigung von insbesondere großflächigen Halbleiterchips (z.B. Leistungshalbleitern) auf Substraten, wie in der **DE-A 44 17 285** (Finetech) beschrieben.

Durch Benutzung der Öffentlichkeit zugänglich gewordene Verfahren zum Löten oder Anbringen von Leistungshalbleitern sind:
1. Reflowlöten mit Lotpaste und aggressiven Flußmitteln, ggf. auch ergänzt durch Silber- oder Kupferpartikel, die in **EP-A 110 307** (Burroughs) gemäß dortiger Seite 10, Zeilen 1 bis 20 bei höherer Temperatur geschmolzen werden, um eine **nachträgliche Metallisierung** der Kontaktflächen beim Löten zu ermöglichen.
2. Bilden einer **eutektischen Bondverbindung** unter Vakuum **EP-A 361 715** (UCLA), wobei die Bondverbindung nur eine Schichtdicke von weniger als 10 µm aufweist. Als Verbindungspartner werden ein Siliziumchip und ein Siliziumsubstrat vorgesehen, zwischen beiden wird eine dünne Goldschicht eingefügt und **mit hohem Druck** unter Vakuum gepreßt, wobei zusätzlich eine Erwärmung auf etwa 400°C vorgesehen wird (vgl. dort Seite 3, Zeilen 28 bis 33, Seite 4, Zeilen 11 bis 14 und 20 bis 22 sowie dortige Ansprüche 3 und 8).
3. Bloßes Einsetzen der Chips in ein flüssiges Lot.

Großflächige Halbleiterchips (Leistungshalbleiter) müssen gut gekühlt werden. Hierzu werden sie in metallische Gehäuse, auf Leiterplatten mit metallischem Kern, Dickschichtschaltungen auf keramischen Substraten oder DCB (Direct Copper Bonding) Substraten gelötet. Die Hauptschwierigkeit beim Löten von großen Halbleitern (Kantenlänge größer 4mm) ist es, die Lötung lunkerfrei und mit definierter Schichtdicke des Lotes auszuführen und eine - durch das beim Schwimmen der Chips auf dem Lot beeinflußte - **Positionsgenauigkeit** zu erreichen, mit der erst eine hohe Packungsdichte möglich ist. In einem integrierten Frequenzumrichter befinden sich heute auf einem Substrat zwischen 18 und ca. 100 Leistungshalbleiter. Die Qualität des Lötverfahrens und dessen Reproduzierbarkeit sind damit von großer Bedeutung für die Qualität des Produktes. Auch schon geringe Lunkeranteile können die Gesamtschaltung mit einem hohen Wert unbrauchbar, zumindest aber störanfällig machen.

**Die Aufgabe** der Erfindung liegt darin, die Positioniergenauigkeit der Chips beim Löten deutlich zu erhöhen. Das wird gemäß Anspruch 1 oder Anspruch 10 erreicht.

Die Sicherheit und Genauigkeit des Lötprozesses wird erfindungsgemäß dadurch verbessert, daß der Lötvorgang im Vakuum in das flüssige Lot hinein erfolgt und die Chips seitenstabil gehalten und durch das sich aufbauende Vakuum auf den zu lötenden Träger (das Substrat) gedrückt werden (Anspruch 1). Das Verfahren ermöglicht sichere lunkerfreie Lötung auch von Substraten mit vielen Chips. Die Chips "schwimmen" nicht mehr auf dem Lot. Das Verfahren läßt sich leicht automatisieren, da keine Batchprozesse erforderlich sind, und kann leicht in Bestückungs- und Bondeinrichtungen integriert werden. Die Zykluszeiten sind kurz.

Die Schichtdickeneinstellung des Lotes erfolgt durch im Lot befindliche Kugeln mit einer Schmelztemperatur, die höher als die Löttemperatur ist (Anspruch 14). Durch erzwungene sehr schnelle Kühlung kann die Kornbildung und damit die Zyklenfestigkeit beim Erstarren des Lotes verbessert werden (Anspruch 5).

Eine Vorrichtung zum Ausführen des vorgenannten Verfahrens (Anspruch 10) besteht aus einem Oberteil (als Deckel ausgestaltet) mit einer seitenstabilen Aufnahme für die Chips in ihrer Bestückposition, einem Unterteil (als Heizplatte gestaltet), wenigstens einem Vakuumanschluß, einem Gasanschluß zum Kühlen und einem flexiblen Dichtungssystem zwischen Oberteil und Unterteil, welches temperaturstabil und elastisch ist, um eine Relativbewegung von Oberteil und Heizplatte zu erlauben. Ein weiterer Gasanschluß zum Fluten mit Schutzgas kann vorgesehen sein (Anspruch 13).

Die Größe des Lötraums ist gering (Anspruch 12). In Lateralrichtung werden die Chips von Saugern oder einer Lochmatte unter Vakuum und seitlich geführt gehalten (Anspruch 11).

**Anwendungsgebiete** der Erfindung liegen beim Auflöten von Leistungshalbleitern und großen Chips mit hoher Verlustleistung, insbesondere bei Multi-Chip-Systemen. Die Substrate werden allgemein auch mit "Leiterplatte" bezeichnet.

Vakuumlötverfahren gem. der eingangs erwähnten Ziffer 2 erfolgen im Batchbetrieb. Die Lötzeiten sind sehr lang. Die Ergebnisse bezüglich der Lotschichtdicken sind ungenau und nicht sicher reproduzierbar. Die Chips schwimmen auf dem Lot, was die Positioniergenauigkeit reduziert. Mit der Erfindung wird dagegen sowohl die Prozeß-Stabilität erhöht, wie auch die Konstanz der Eigenschaften der Lötung deutlich verbessert. Als Nebeneffekt ergibt sich ein geringerer Energieverbrauch gegenüber üblichen Lötmaschinen, trotz deutlich reduzierter Prozesszeit. Die Erfindung ermöglicht auch eine Einhaltung einer Vielzahl von Parametern, wie der Bestandteile und die Mischung der Pasten, das Aufbringen der Lotpaste und die Temperaturprofile der Oberflächen.

Die Schichtdicke des Lotes kann durch in der flüssigen Phase des Lotes feste Bestandteile definierter Größe garantiert werden (Anspruch 14). Solche Bestandteile können zum Beispiel Kupferkügelchen, wie sie in Sinterprozessen verwendet werden, sein. Auch Siliziumkugeln eignen sich wegen der angepassten Ausdehnung gegenüber dem Lotpartner gut. Hierzu werden in das Lot geringe Prozente von "Abstandshaltern" (z.B. Kupferkugeln) eingebunden. Um eine gleichmäßige Schichtdicke zu erhalten, sollen wenigstens drei feste "Abstandshalter" unter jedem zu lötenden Chip sein. Die obere Grenze ist dadurch bestimmt, daß das Lot sich zu einer Schicht mit nur einer Lage "Abstandshalter" zusammenpressen lassen muß. Günstige Verhältnisse sind 10% bis 20% feste Bestandteile im Lot (Anspruch 17). Die Eigenschaften des Lotes können zudem durch das Beimengen geeigneter Materialien positiv eingestellt werden.

Die Erfindung wird nachfolgend anhand mehrerer Ausführungs**beispiele** erläutert und ergänzt.
- **Figur 1**: schematisiert den Ausgangspunkt eines Lötvorgangs zwischen einem Chip 1 und einem Substrat 20 mit einer entspannten Dichtung 11 an einem Gehäuse 3,4. Das Lotmaterial 9 beinhaltet kugelförmige Abstandshalter 10.
- **Figur 2**: verdeutlicht die Abwärtsbewegung x₁ des Oberteils 3 des Gehäuses, das Absenken des seitenstabil gehaltenen Chips 1 und die Kompression der Dichtung 11, bis die Abstandskugeln 10 die Abwärtsbewegung begrenzen und die Lage des Chips 1 fest liegt (Lötphase).
- **Figur 3**: veranschaulicht das Aufwärtsbewegen x₂ des Chips 1 mit gelötetem Substrat 20 und die Kühlung 5 unter dem Substrat, bei sich entspannender Dichtung 11. Die Lage und der Abstand des Chips 1 von dem Substrat 20 bleibt unverändert.

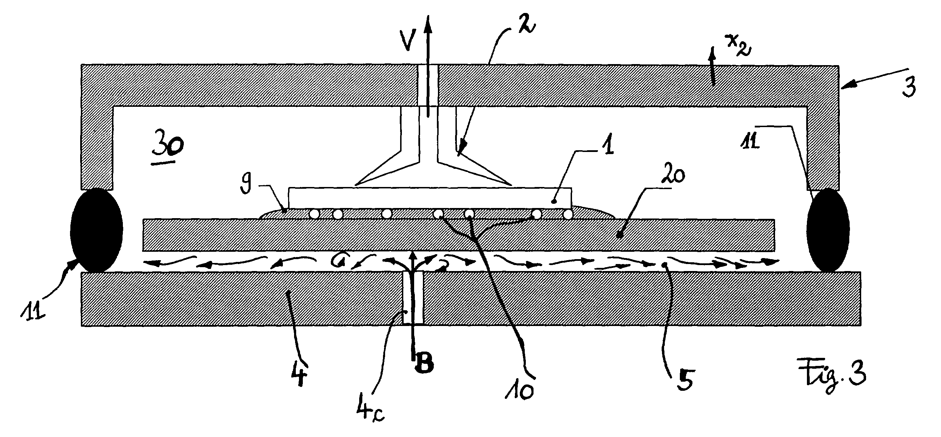

Der Löt-Prozeß beginnt in **Figur 1** mit dem Einsetzen einer Leiterkarte 20 auf die Heizplatte 4. Dort wird die Leiterkarte fest angebracht, so daß gute Wärmeleitung ermöglicht ist. Auf der Leiterkarte 20 ist das Lot 9 mit nichtschmelzenden Teilchen 10 mittels Siebdruck oder Preforms aufgebracht. Die Heizplatte 4 bringt die Leiterkarte 20 je nach Basismaterial in einigen Sekunden bis zu einigen 10 Sekunden auf Löttemperatur. Während dieser Zeit kann zur Reduzierung der Oxidation Schutzgas in die Kammer 30 zwischen Oberteil 3 und Unterteil 4 eingeblasen werden. Das sehr geringe Volumen läßt es zu, mit geringen Gasvolumina geringe Restsauerstoffgehalte zu erzielen.

Ob Schutzgas eingesetzt werden muß, hängt von den Löttemperaturen und den Oberflächen der Lötpartner ab. Die kurzen Lötprozesszeiten, die mit dem Verfahren möglich sind (ca. 60sec gegenüber 1800sec im Stand der Technik) reduzieren schon die Gefahr der Oxidation ganz wesentlich. In vielen Fällen kann daher eine Schutzgasatmosphäre sogar entfallen, was die Wirtschaftlichkeit des Prozesses weiter verbessert.

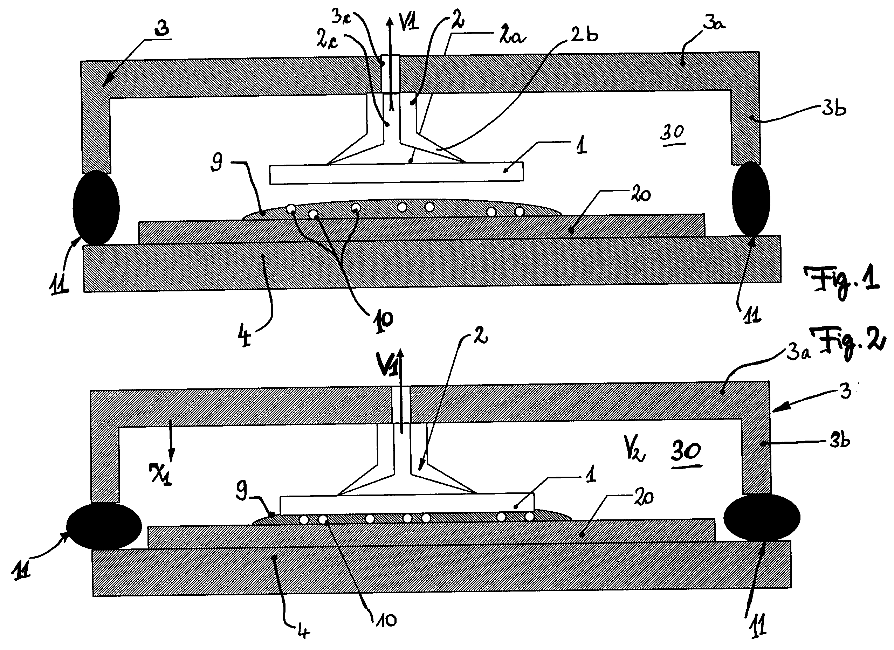

Im zweiten Prozesschritt gemäß **Figur 2** wird durch das Einschalten des Vakuums V der Deckel 3 mit den Chips 1 langsam auf die inzwischen mit flüssigem Lot benetzte Leiterkarte 20 gedrückt. Die durch temperaturfeste Siliconsauger 2b gehaltenen und in Vertikalrichtung leicht elastisch oder federnd an den Deckel gebundenen Chips 1 werden durch das entstehende Vakuum auf die Leiterplatte 20 gedrückt. Das gesteuerte Vakuum sorgt für ein langsames lunkerfreies Aufsetzen der Chips 1 mit durch die beschriebenen "Abstandshalter" 10 garantiertem Abstand von dem Substrat 20. Die Chips werden durch den Deckel permanent seitlich geführt und gehalten und können daher auch nicht wegschwimmen. Die Positioniergenauigkeit wird verbessert.

Im folgenden, dritten Prozeßschritt gemäß **Figur 3** wird das noch flüssige Lot 9 durch Einblasen von kaltem Gas B in sehr kurzer Zeit (möglichst unter 10 sec) unter die Erstarrungstemperatur abgekühlt. Neben dem Vorteil der hierdurch verbesserten Gefügeeigenschaften ergibt sich eine sehr kurze Prozesszeit durch das Gaspolster 5, das sich unter dem Chip und dem Substrat 1,20 bildet und dies kühlend anhebt.

Der Deckel 3 hat eine Aufnahmevorrichtung 2 für zumindest einen, bevorzugt aber viele Chips 1 in den Bestückpositionen (z. B. Siliconmatte mit Löchern 2c oder kleine Sauger mit Innenkanal 2c). Die Heizplatte 4 mit wenigstens einer Öffnung 4c zum Einblasen des Kühlmediums und eine Vorrichtung zum Aufsetzen des Deckels 3 und zur Bestückung der Heizplatte mit der "Leiterkarte" 20 sind ergänzend vorgesehen. Letztere Vorrichtung kann eine Handhabungseinrichtung, z. B. ein Scara Roboter, sein, der die nötigen Handhabungen ausführt.

Ein typischer Prozessablauf in einem Fertigungsprozeß zur Herstellung von Substraten mit gelöteten Leistungshalbleitern ist:
1. Einsetzen der Leiterplatte 20 auf die Heizplatte (ca. 250°C).
2. Ansaugen der Leistungshalbleiter 1 über Vakuum V1 aus einem Bestücknest mit dem "Deckel" als Oberteil 3 und seitenstabile Halterungen der mehreren Chips 1, wobei sie in Vertikalrichtung elastisch oder federnd nachgiebig positioniert sind, z. B. über eine Siliconmatte oder einzelne (individuelle) Sauger 2.
3. Aufsetzen des Deckels 3 über der Leiterplatte (mechanisch zentriert), um einen umfänglich abgedichteten Vakuumraum 30 zu bilden.
4. Mit Schutzgas spülen.
5. Vakuum V2 einschalten nach Erreichen der Schmelztemperatur des Lotes 9 und Evakuieren des Vakuumraums 30 (Lötraum).
6. Deckel mit Chips wird durch das Vakuum V2 zwischen der Heizplatte 4 und dem Deckel 3 seitlich unverrückbar geführt und abgesenkt in das flüssige Lot. Keine seitliche Verrückung der Chips tritt beim vakuum-forcierten Ansaugen des Deckelteils auf, allenfalls beim Aufdrücken des Chips 1 tritt eine elastische Komponente in Bewegungsrichtung hinzu, die die Chips 1 gegen die Kornbestandteile 10 im Lot 9 drückt und damit großflächig für einen gleichmäßigen Abstand ohne Beschädigung des Halbleiterchips 1 sorgt.
7. Löten.
8. Kaltes Gas B unter die Leiterkarte blasen und damit die Leiterkarte auf einem Gaspolster 5 abkühlen. Gleichzeitig wird das Vakuum V2 im Lötraum 30 kontinuierlich beendet und der Deckel 3 mit seinen Seitenwänden 3a,3b entfernt sich ebenso kontinuierlich von der Heizplatte 4 in eine Endlage, die er vor Einschalten des Vakuums eingenommen hatte. Dabei werden die Chips 1 **mit** dem angelöteten Substrat 20 mitgenommen. Auch das Substrat hebt also von der Heizplatte 4 ab.
9. Deckel mit gelöteter Leiterkarte 20 abnehmen und Leistungshalbleiter mit Leiterkarte (Substrat) 20 freigeben.

In konstruktiver Natur ist der Deckel 3 in den Figuren als Haube gezeichnet mit einem mittleren Deckelabschnitt 3a und Seiten-Flanschabschnitten 3b, die über eine umlaufende elastische Dichtung 11, die temperaturstabil ist, mit der Heizplatte 4 abdichtend in Verbindung steht. Durch die elastische Dichtlippe 11 ist eine Bewegungsmöglichkeit des Deckels 3 gegeben. Er kann sich, veranlaßt durch das Vakuum im Lötraum 30, aufwärts und abwärts bewegen, was zum Eindrücken des Leistungschips 1 in das Lot 9 mit seinen Kügelchen 10 eingesetzt wird und dem Abheben von gelöteten Chips mit Leiterkarte dienen kann.

Das Chip 1 ist in **Figur 1** über einen Einzelsauger 2 gehalten, noch oberhalb dem dort schon erwärmten Lot 9. Der Einzelsauger 2 besteht aus einem zylindrischen Abschnitt, durch den ein Mittenkanal 2c hindurchführt, der in einen erweiterten Saugraum 2a mündet, über den das Chip 1 angesaugt wird. Eine umlaufende Greifklaue, die abdichtend mit dem Chip in Verbindung steht, ist an die Abmessung des Chips 1 angepaßt. Diese Greifklaue 2b hat im wesentlichen konische Gestalt und ist sehr flach verlaufend ausgebildet. Der erwähnte Kanal 2c im zylindrischen Rumpf mündet in einen Durchtritt 3c am Deckelteil, so daß von außen das Vakuum V1 zum Halten der Chips 1 aufgebracht und gelöst werden kann.

**Figur 2** veranschaulicht das Hereindrücken des Leistungs-Halbleiters 1 in das flüssige Lot, wobei die Abstandshalter 10 als Kugeln den definierten Abstand des Halbleiters 1 von dem Substrat 20 festlegen. Der Einzelhalter 2 begründet eine seitenstabile Positionierung des Chips 1, er kann leicht nachgiebig in Vertikalrichtung gehalten sein, sei es durch eine Federlagerung oder durch Unterlegen von Siliconmatten oder - scheiben zwischen seinem zylindrischen Rumpf und dem Deckel 3a.

In der **Figur 2** ist die Abwärtsbewegung des Deckels mit x₁ angedeutet. Der Dichtungsrichtung 11 ist komprimiert gegenüber der **Figur 1**, gleichzeitig aber abdichtend. Der Lötraum 30 steht unter Vakuum V2. Erst durch Lösen dieses Vakuums gemäß **Figur 3** hebt sich der Deckel 3 wieder an, was durch die Bewegungsrichtung x₂ angedeutet ist.

Beide Bewegungen sind reine Axial-Bewegungen. Zusammen mit dem seitlich stabilen Halten der Chips an dem Oberteil wird ein genau geführtes Eindrücken des Chips 1 in das Lot 9, 10 erreicht, mit dem ein "Schwimmen" vermieden werden kann.

Das einströmende Gas B durch ein im Bodenbereich (in der Heizplatte 4) vorgesehenen Kanal 4c erlaubt eine gleichmäßige und sichere Kühlung des Chips 1 über das Substrat 20. Das Substrat 20 schwebt dabei auf einem Gaspolster, ist aber gleichzeitig gehalten von dem Halter 2, über das erstarrende Lot 9. Die Zufuhr des Kühlgases B ist gleichzeitig das Aufheben des Vakuums V2, während das Vakuum V zur Halterung des Chips 1 mit nun daran angelötetem Substrat 20 erhalten bleibt, bis die Kühlwirkung des Gases B ausreichend war, um das Lot sicher und vollständig zu erstarren.

Nicht dargestellt ist die Entnahme des fertig gelöteten Chips 1 - oder der mehreren Chips 1 mit genau definiertem Abstand auf dem Substrat 20 -, wozu der Deckel 3 abgehoben werden kann oder die Heizplatte 4 seitlich verschoben werden kann, unter Mitnahme des Dichtungsrings 11.

Die Erfindung betrifft ein Verfahren zum positionsgenauen Auflöten von flächigen Halbleiterchips (1) auf ein Substrat (20), bei dem ein Vakuum (V2) in einem Lötraum (30) ein Oberteil (3) gegenüber einem Unterteil (4) relativbewegt und die an dem Oberteil (3) seitenstabil gehaltenen - eines oder mehrere - Chips (1) in das erwärmte Lot (9,10) hineindrückt sowie eine Einrichtung zum Durchführen dieses Verfahrens. Ferner wird Lotmaterial zur Anbringung von großen Halbleiterchips, insbesondere Leistungshalbleitern (1), bereitgestellt, mit einem bei einer Schmelztemperatur flüssig werdenden Lötbestandteil (9) und einer Vielzahl von Körnern (10), die gegenüber dem Lötmaterial resistent sind und eine Schmelztemperatur haben, die höher liegt, als die Schmelztemperatur des Lotbestandteils (9).

## Patentansprüche

1. **Verfahren** zum positionsgenauen Auflöten (9,10) von zumindest einem flächigen Halbleiterchip (1) auf einem Substrat (20), bei dem
(a) durch ein Vakuum (V2) in einem Lötraum (30) ein Oberteil (3) gegenüber einem Unterteil (4) mechanisch zentriert relativbewegt wird (x₁,x₂), während das Substrat (20) auf dem Unterteil (4) angeordnet ist;
(b) das zumindest eine Halbleiterchip (1) bei der Relativbewegung an dem Oberteil (3) seitenstabil gehalten in das erwärmte Lot (9,10) hineingedrückt wird.

2. Verfahren nach Anspruch 1, bei dem das mindestens eine flächige Chip (1) ein großflächiger Leistungs-Halbleiter ist.

3. Verfahren nach einem der obigen Ansprüche, bei dem der Lötraum (30) von einem haubenartigen Oberteil (3;3a,3b) gebildet wird, dessen Seitenwände (3b) einen komprimierbaren Dichtungsring (11) unter Einfluß des Vakuums zusammendrücken, bis der mindestens eine Halbleiterchip (1) seine Lötlage mit einem definierten Abstand (10) von dem Substrat (20) erreicht hat.

4. Verfahren nach einem der obigen Ansprüche, bei dem der Lötraum (30) vor Aufschmelzen des Lotes (9) auf das Substrat (20) mit Schutzgas geflutet oder gespült wird.

5. Verfahren nach einem der obigen Ansprüche, bei dem nach Absenken des mindestens einen Halbleiterchips (1) in das Lot (9,10) ein Kühlgas (B) von unten (4c) gegen das Substrat (20) gedrückt wird, um ein gleichmäßig kühlendes Luftpolster (5) auszubilden.

6. Verfahren nach einem obiger Ansprüche, bei dem das Substrat (20) fest auf dem Unterteil (4), inbesondere einer darauf angeordneten Heizplatte angebracht wird, bevor die Relativbewegung einsetzt, bei der eine seitliche Verrückung von Oberteil und Unterteil (3,4) verhindert wird.

7. Verfahren nach einem der erwähnten Ansprüche, bei dem der mindestens eine Halbleiterchip (1) in Vertikalrichtung elastisch, inbesondere federnd nachgiebig, gehalten wird.

8. Verfahren nach einem der obigen Ansprüche, bei dem die mechanisch zentrierte Bewegung eine permanent seitlich geführte oder gehaltene Abwärtsbewegung des Oberteils in Richtung auf das vertikal unbewegte Unterteil (4) ist, zumindest während der Auflötphase des Verfahrens.

9. Verfahren nach einem der obigen Ansprüche, bei dem verhindert wird, daß das Oberteil und das Unterteil (3,4) zumindest bei ihrer Relativbewegung in vertikaler Richtung seitlich verrückbar sind, insbesondere aber eine seitliche Verrückung zugelassen wird, bei Entnahme des gelöteten Halbleiters (1) auf dem Substrat (20).

10. Vorrichtung zum Ausführen des Verfahrens nach einem der Ansprüche 1 bis 9, welche Vorrichtung beinhaltet:
(a) ein Oberteil (3;3a,3b) mit einer Aufnahmevorrichtung (2) für Halbleiterchips (1) in den Bestückpositionen;
(b) eine Einrichtung zum Aufsetzen des Oberteils (3) und zur vorherigen Bestückung eines flachen Unterteils (4) mit einem Substrat (20);
**dadurch gekennzeichnet, daß**
(c) das Unterteil als Heizplatte (4) mit wenigstens einer Öffnung (4c) zum Einblasen eines Kühlmediums (B) ausgebildet ist;
(d) das Oberteil (3) Seiten-Flanschabschnitte (3b) hat, die über eine temperaturstabile elastische Dichtung (11) mit der Heizplatte (4) elastisch in Verbindung stehen, um eine Relativbewegung (x₁,x₂) von Oberteil (3) und Heizplatte (4) zu erlauben.

11. Vorrichtung nach Vorrichtungsanspruch 10, bei der die Aufnahmevorrichtung (2) eine Siliconmatte mit Löchern (2c,3c) ist oder aus kleinen individuellen Saugern besteht, um das oder die Chips (1) permanent während des Lötvorgangs seitlich zu führen oder zu halten.

12. Vorrichtung nach einem der obigen Vorrichtungsansprüche, bei der der von Oberteil (3) und Unterteil (4) gebildete Lötraum (30) klein hinsichtlich seines Volumens ausgebildet ist, indem er eine horizontale Erstreckung hat, die etwa der Größe einer das Substrat bildenden Leiterkarte (20) entspricht und in Vertikalrichtung nur geringfügig höher ausgebildet ist, als für die Unterbringung von Substrat (20), Lotschicht (9,10) und Chip (1) sowie Chiphalter (2;2a,2b,2c) erforderlich ist.

13. Vorrichtung nach einem der erwähnten Vorrichtungsansprüche, bei der eine oder zwei Öffnungen zum Fluten und Abziehen bzw. Spülen mit Schutzgas zum Lötraum (30) führen.

14. **Lotmaterial** (9,10) zur Anbringung von großen Halbleiterchips (1) insbesondere Leistungshalbleitern (1), nach einem der Ansprüche 1 bis 10 oder in einer Vorrichtung nach einem der Ansprüche 10 bis 13, welches Lot eine bei einer Schmelztemperatur flüssig werdenden Lötbestandteil (9) und eine Vielzahl von Körnern (10) beinhaltet, die gegenüber dem Lötbestandteil resistent sind und eine Schmelztemperatur haben, die höher als die Schmelztemperatur des Lotbestandteils (9) ist und im Durchmesser auf einen zu erreichenden Abstand zwischen dem Substrat (20) und dem aufzulötenden Halbleiterchip (1) abgestimmt sind.

15. Lotmaterial nach Anspruch 14, bei dem die Schmelztemperatur der Körner (10) deutlich oberhalb der Schmelztemperatur des Lötbestandteils (9) liegt.

16. Lotmaterial nach Anspruch 14 oder 15, bei dem die Körner Kugeln, insbesondere aus Glas, Kupfer oder Silizium sind.

17. Lotmaterial nach einem der Ansprüche 14 bis 16, bei dem der Anteil der Körner gegenüber dem Lotbestandteil wenige Gewichtsprozente beträgt, insbesondere der Kornanteil unter 20 Gew-% liegt.
